(19) Europäisches Patentamt European Patent Office Office européen des brevets

(11) **EP 3 775 946 B1**

(12) **EUROPEAN PATENT SPECIFICATION**

(45) Date of publication and mention of the grant of the patent:
**08.05.2024   Bulletin 2024/19**

(21) Application number: **18912563.6**

(22) Date of filing: **28.03.2018**

(51) International Patent Classification (IPC):
*G01R 31/327* *(2006.01)*

(52) Cooperative Patent Classification (CPC):
**G01R 31/3277**

(86) International application number:
**PCT/CN2018/080946**

(87) International publication number:
**WO 2019/183851 (03.10.2019 Gazette 2019/40)**

(54) **APPARATUS AND METHOD FOR FAULT DIAGNOSIS FOR CIRCUIT BREAKER**

VORRICHTUNG UND VERFAHREN ZUR FEHLERDIAGNOSE FÜR SCHUTZSCHALTER

APPAREIL ET PROCÉDÉ DE DIAGNOSTIC DE DÉFAILLANCE POUR DISJONCTEUR

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**17.02.2021   Bulletin 2021/07**

(73) Proprietor: **ABB Schweiz AG**
**5400 Baden (CH)**

(72) Inventors:
• **ZHANG, Xin**
  **Xiamen, Fujian 361004 (CN)**
• **ZHUANG, Zhijian**
  **Xiamen, Fujian 361021 (CN)**

(74) Representative: **Zimmermann & Partner**
**Patentanwälte mbB**
**Postfach 330 920**
**80069 München (DE)**

(56) References cited:
WO-A1-2016/206056   CN-A- 104 965 170
CN-A- 105 975 737   CN-U- 203 259 629
CN-U- 203 259 629   CN-U- 205 450 212
CN-U- 205 679 738   US-A1- 2010 033 888
US-A1- 2014 055 903

## Description

### FIELD

Embodiments of the present disclosure generally relate to a circuit breaker, and more specifically, to fault diagnosis apparatus and method for a circuit breaker.

### BACKGROUND

A Circuit breaker being widely used in industrial and home applications is well-known. The circuit breaker is an automatically operated electrical switch designed to protect an electrical circuit from damage caused by overcurrent, typically resulting from an overload or short circuit. Once a fault of the circuit is detected, the circuit breaker contacts must open to interrupt the circuit, which is commonly done using mechanically stored energy contained within the circuit breaker, such as a spring or compressed air to separate the contacts. Circuit breakers may also use the higher current caused by the fault to separate the contacts, such as thermal expansion or a magnetic field. Circuit breakers typically use tripping coil to trip the operating mechanism, and charging motor to restore energy to the springs.

It can be seen that the stability of a circuit breaker is mainly determined by the health status of the operating mechanism, the tripping coil and the charging motor. With long term use, the operating mechanism, the transmission mechanism between the operating mechanism and the tripping coil and the transmission mechanism between the springs and the charging motor may malfunction. For example, the components in the above operating mechanism or the transmission mechanisms may be worn, deformed or broken, or joints between the components may be obstructed with rotating due to the deformation or the increased interval.

The above mentioned problems may cause the circuit breaker to operate poorly and eventually result in the fault of the circuit breaker. CN203259629U describes a diagnostic instrument for high-voltage breaker mechanical fault; WO2016/206056A1 describes a circuit breaker detection method, device and system; CN105975737A describes a turning point calculation model and breaker state monitoring method and system for motor current. In conventional solutions, the above problems may be detected or discovered only after the problems have caused the fault of the circuit breaker. This may cause the damage to the electrical appliance in the circuit. Furthermore, in this case, the circuit breaker may only be handled passively, for example by replacement, to solve the above problems. Thus, the replacing time of the circuit breaker is prolonged compared with the case of replacing the circuit breaker actively or in advance.

### SUMMARY

Embodiments of the present disclosure provide a solution for providing a fault diagnosis apparatus and method for a circuit breaker.

In a first aspect, a fault diagnosis apparatus for a circuit breaker is provided. The apparatus comprises at least one sensor coupled to at least one mechanism arranged in the circuit breaker and configured to obtain waveform data of a parameter over time, the waveform data related to an operation state of the at least one mechanism; and a processing unit coupled to the at least one sensor and configured to analyze the waveform data to obtain at least one feature value; determine a dissimilarity between the at least one feature value and a threshold matrix; and in response to the dissimilarity being greater than a threshold dissimilarity, determine that the at least one mechanism has a fault.

In some embodiments, the processing unit determines the dissimilarity based on a Nonlinear State Estimate Technique.

The threshold matrix records feature values corresponding to a normal operation status of the at least one mechanism.

The threshold matrix records 50 or more vibration feature values.

In some embodiments, the at least one mechanism comprises an operating mechanism of the circuit breaker, and the at least one sensor comprises a vibration sensor arranged on the operating mechanism, the vibration sensor configured to obtain vibration waveform data related to open/close operation of the operating mechanism.

In some embodiments, the at least one mechanism comprises a tripping coil of the circuit breaker, and the at least one sensor comprises a first hall sensor coupled to the tripping coil, the first hall sensor configured to obtain first current waveform data related to a tripping operation of the tripping coil.

In some embodiments, the at least one mechanism comprises a charging motor of the circuit breaker, and the at least one sensor comprises a second hall sensor coupled to the charging motor, the second hall sensor configured to obtain second current waveform data related to a charging operation of the charging motor.

In some embodiments, the processing unit is further configured to filter the vibration waveform data based on Wavelet Transform.

In some embodiments, the processing unit is configured to analyze the filtered vibration waveform data to obtain at least one vibration feature value, the at least one vibration feature value comprising a peak value determined from the filtered vibration waveform data.

In some embodiments, the processing unit is configured to analyze the first current waveform data to obtain at least one tripping feature value, the at least one tripping feature value comprising an operating peak value and/or an operating time determined from the first current waveform data.

In some embodiments, the processing unit is configured to analyze the second current waveform data to obtain at least one charging feature value, the at least one charging feature value comprising a startup current, a cut-off current, an average charging current and/or a charging time determined from the second current waveform data.

In second aspect, a circuit breaker comprising the above mentioned fault diagnosis apparatus is provided.

In third aspect, a fault diagnosis method for a circuit breaker is provided. The method comprises receiving, from at least one sensor coupled to at least one mechanism arranged in the circuit breaker, waveform data of a parameter over time, the waveform data related to an operation state of the at least one mechanism; analyzing the waveform data to obtain at least one feature value; determining a dissimilarity between the at least one feature value and a threshold matrix; and in response to the dissimilarity being greater than a threshold dissimilarity, determining that the at least one mechanism has a fault.

In some embodiments, the dissimilarity is determined based on a Nonlinear State Estimate Technique.

The method further comprises establishing the threshold matrix with feature values corresponding to a normal operation status of the at least one mechanism. The threshold matrix records 50 or more vibration feature values.

In some embodiments, the method comprises receiving, from a vibration sensor arranged on an operating mechanism of the circuit breaker, vibration waveform data related to open/close operation of the operating mechanism.

In some embodiments, the method comprises receiving, from a first hall sensor coupled to a tripping coil of the circuit breaker, first current waveform data related to a tripping operation of the tripping coil.

In some embodiments, the method comprises receiving, from a second hall sensor coupled to a charging motor of the circuit breaker, second current waveform data related to a charging operation of the charging motor.

In some embodiments, the method further comprises filtering the vibration waveform data based on Wavelet Transform.

In some embodiments, the method comprises analyzing the filtered vibration waveform data to obtain at least one vibration feature value, the at least one vibration feature value comprising a peak value determined from the vibration waveform data.

In some embodiments, the method comprises analyzing the first current waveform data to obtain at least one tripping feature value, the at least one tripping feature value comprising an operating peak value and/or an operating time determined from the first current waveform data.

In some embodiments, the method comprises analyzing the second current waveform data to obtain at least one charging feature value, the at least one charging feature value comprising a startup current, a cut-off current, an average charging current and/or a charging time determined from the second current waveform data.

It is to be understood that the Summary is not intended to identify key or essential features of embodiments of the present disclosure, nor is it intended to be used to limit the scope of the present disclosure. Other features of the present disclosure will become easily comprehensible through the description below.

## BRIEF DESCRIPTION OF THE DRAWINGS

The above and other objectives, features and advantages of the present disclosure will become more apparent through more detailed depiction of example embodiments of the present disclosure in conjunction with the accompanying drawings, wherein in the example embodiments of the present disclosure, same reference numerals usually represent same components.

FIG. 1 shows a schematic diagram of a circuit breaker with a fault diagnosis apparatus according to embodiments of the present disclosure;

FIG. 2 shows a perspective view of the circuit breaker with the fault diagnosis apparatus according to embodiments of the present disclosure;

FIG. 3 shows a perspective view of an operating mechanism with a vibration sensor arranged thereon according to embodiments of the present disclosure;

FIGs. 4A and 4B show schematic diagrams of a tripping coil and a charging motor coupled to hall sensors according to embodiments of the present disclosure;

FIGs. 5A and 5B show diagrams of vibration waveform data and filtered vibration waveform data according to embodiments of the present disclosure respectively;

FIG. 6 shows a diagram of a vibration feature value as a function of the number of close operations of the operating mechanism;

FIG. 7 shows a perspective view of a tripping coil according to embodiments of the present disclosure;

FIG. 8 shows a diagram of first current waveform data related to the tripping coil according to embodiments of the present disclosure;

FIG. 9 shows a diagram of a tripping feature value as a function of the number of tripping operations of the tripping coil;

FIG. 10 shows a diagram of second current waveform data related to the charging motor according to embodiments of the present disclosure;

FIG. 11 shows a diagram of a charging feature value as a function of the number of charging operations of the charging motor;

FIG. 12 shows a flowchart of a fault diagnosis method for the circuit breaker according to some other embodiments of the present disclosure.

Throughout the drawings, the same or similar reference symbols are used to indicate the same or similar elements.

## DETAILED DESCRIPTION

The present disclosure will now be discussed with reference to several example embodiments. It is to be understood these embodiments are discussed only for the purpose of enabling those skilled persons in the art to better understand and thus implement the present disclosure, rather than suggesting any limitations on the scope of the subject matter.

As used herein, the term "comprises" and its variants are to be read as open terms that mean "comprises, but is not limited to." The term "based on" is to be read as "based at least in part on." The term "one embodiment" and "an embodiment" are to be read as "at least one embodiment." The term "another embodiment" is to be read as "at least one other embodiment." The terms "first," "second," and the like may refer to different or same objects. Other definitions, explicit and implicit, may be comprised below. A definition of a term is consistent throughout the description unless the context clearly indicates otherwise.

In a circuit breaker, an operating mechanism and transmission mechanisms related to a tripping coil and a charging motor may fail with long term use. Failure of the above mechanisms may cause malfunction of the circuit breaker. In the conventional solutions, the above problems may be detected or discovered only after the problems have caused the fault of the circuit breaker. This may cause the damage to the electrical appliance in the circuit and prolonged replacing time of the circuit breaker.

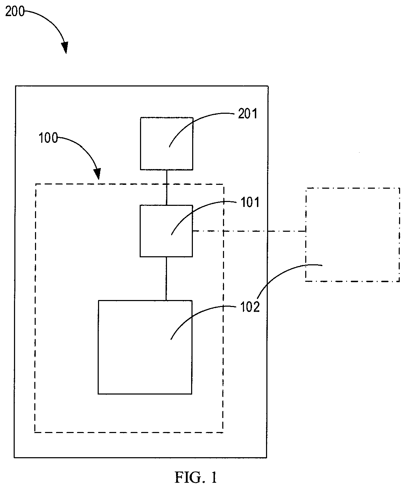

In order to detect or determine a fault in the above mechanisms before the fault occurs, embodiments of the present disclosure provide a fault diagnosis apparatus 100 for a circuit breaker 200. Now some example embodiments will be described with reference to FIGs. 1-11.

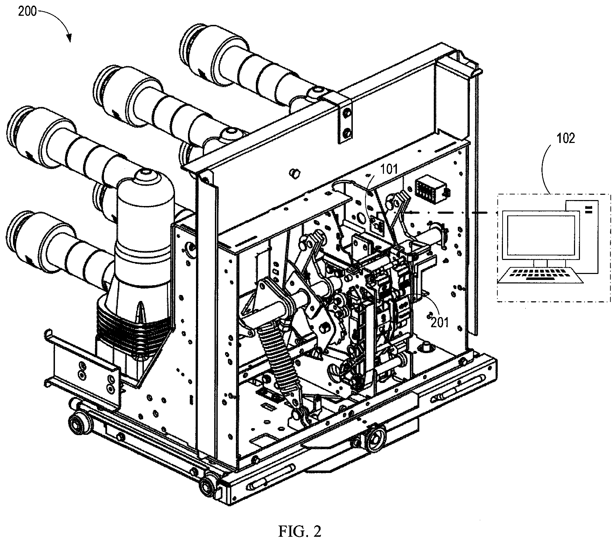

FIG. 1 shows a schematic diagram of a circuit breaker 200 with a fault diagnosis apparatus 100 according to embodiments of the present disclosure; and FIG. 2 shows a perspective view of the circuit breaker 200 with the fault diagnosis apparatus 100 according to embodiments of the present disclosure.

Generally, as shown in FIGs. 1 and 2, the fault diagnosis apparatus 100 comprises at least one sensor 101 and a processing unit 102 coupled to the at least one sensor 101. The sensor 101 coupled to at least one mechanism 201 arranged in the circuit breaker 200 to detect and obtain waveform data of a parameter over time. The waveform data is related to an operation state of the at least one mechanism 201.

The inventors found that the waveform data of the parameter over time, such as vibration magnitude, current or the like, may change before faults in the above mechanisms occur. Although no malfunction has occurred, the health status of the mechanism deteriorates due to deformation or the like. The poor health status may cause the malfunction of the circuit breaker 200 at any time.

The inventors also found that the poor health status may be detected by analyzing the above waveform data. Therefore, the processing unit 102 is configured to analyze the above waveform data to obtain at least one feature value.

Then the processing unit 102 determines a dissimilarity between the at least one feature value and a threshold matrix. In response to the dissimilarity being greater than threshold dissimilarity, the processing unit 102 determines that at least one mechanism 201 has a fault.

It will be appreciated that by analyzing the waveform data related to the operation state of the mechanism 201 in the circuit breaker 200, the fault in the mechanism 201 may be determined in advance. A user may take action(s) in advance to solve the problem, before the sudden malfunction of the circuit breaker 200 occurs. For example, when the processing unit 102 determines that at least one mechanism 201 has a fault, which means that it is necessary to replace the circuit breaker 200, the user may turn off the electrical appliances in the circuit in advance to prevent the electrical appliances from damage due to the sudden malfunction of the circuit breaker 200.

Furthermore, the fault diagnosis apparatus 100 according to embodiments of the present disclosure may be easily applied to the all-new circuit breaker 200 or retrofit an existing circuit breaker 200. The fault diagnosis may be performed by coupling the sensors 101 to the mechanisms 201 arranged in the circuit breaker 200 in a cost-effective manner.

In some embodiments, the processing unit 102 may take action when the at least on mechanism 201 having the fault. For example, the processing unit 102 may send an alarm signal to an alarm apparatus (not shown), to cause the alarm apparatus to alarm the user about the fault. Furthermore, the processing unit 102 also may cut off the current in the circuit actively to avoid unnecessary losses.

In some embodiments, the processing unit 102 may be a computer in communication with the at least one sensor 101, as shown in FIG. 2. In such a case, the processing unit 102 may alarm the user by displaying the alarm on a screen of the computer. Alternatively, in some embodiments, the processing unit 102 may be a control modular arranged in the circuit breaker 200. The control module may be a control unit of the circuit breaker itself, or alternatively, it may be another independent control unit 200.

It is to be understood that the above implementation of the processing unit 102 is merely for illustration, without suggesting any limitations as to the scope of the present disclosure. Any other suitable arrangements or components are possible as well. For example, the processing unit 102 may be a cell phone or Personal Digital Assistant (PDA). Furthermore, the processing unit 102 may be coupled to the at least one sensor 101 in a wired or wireless manner.

According to the invention the threshold matrix records feature values corresponding to a normal operation status of the at least one mechanism 201. For example, $n$ feature values ($n$ refers to a natural number greater than 0) may be obtained in one operation by analyzing the waveform data, these feature values may be represented as the following matrix:

$$X(i) = \begin{bmatrix} x_1 & x_2 & \cdots & x_n \end{bmatrix}^T \tag{1}.$$

In the above matrix, "$T$" means the transposition of the matrix. The threshold matrix may record $m$ feature values ($m$ refers to a natural number greater than 0) corresponding to m normal operations of the at least one mechanism 201, which may be represented as below:

$$D = \begin{bmatrix} X(1) & X(2) & \dots & X(m) \end{bmatrix} = \begin{bmatrix} x_1(1) & \cdots & x_1(m) \\ \vdots & \ddots & \vdots \\ x_n(1) & \cdots & x_n(m) \end{bmatrix} \tag{2}$$

In the above equation, $x_n(m)$ means the $n^{th}$ feature value among the feature values obtained in the $m^{th}$ operation of the circuit breaker 200.

It will be appreciated that the greater the value of m, the more accurate the result of dissimilarity. The value of m may be selected as needed. After the feature values have been obtained, in some embodiments, the dissimilarity may be determined based on a Nonlinear State Estimate Technique (NSET), which will be discussed further as below. The NSET algorithm is a simple algorithm that enables the processing unit 102 to execute the algorithm more easily, thereby increasing the response speed of the fault diagnosis apparatus 100.

Specifically, only by way of example, assuming that n feature values related to the operation state of the at least one mechanism 201, $x_1, x_2,..., x_n$, have been obtained, they may be recorded in the following matrix:

$$X_{obs} = \begin{bmatrix} x_1 & x_2 & \cdots & x_n \end{bmatrix}^T \tag{3}$$

The dissimilarity $\varepsilon$ may be determined using the following equation:

$$\varepsilon = X_{obs} - X_{est} \qquad (4)$$

$X_{est}$ may be determined by multiplying the threshold matrix with a coefficient matrix W. The coefficient matrix W may be obtained using the following equation:

$$W = (D^T \otimes D)^{-1} \cdot (D^T \otimes X_{obs}) \qquad (5)$$

In the above equation, "$\otimes$" refers to a nonlinear operator. The nonlinear operator "$\otimes$" may be achieved by various ways. For example, "$\otimes$" may refer to:

$$\otimes(X, Y) = \sqrt{\sum_{i=1}^{n}(x_i - y_i)^2} \qquad (6)$$

After the coefficient matrix W is obtained by the above equation (5), $X_{est}$ may be determined using the following equation:

$$X_{est} = D \cdot W = D \cdot (D^T \otimes D)^{-1} \cdot (D^T \otimes X_{obs}) \qquad (7)$$

The dissimilarity $\varepsilon$ thereby may be determined using the above equation (4). The above describes an exemplary determination process of the dissimilarity based on NSET. It is to be understood that the above implementation of determining the dissimilarity is merely for illustration, without suggesting any limitations as to the scope of the present disclosure. Any other suitable methods and/or algorithms are possible as well. For example, in some embodiments, regression analysis or the like may be used to determine the dissimilarity.

After the dissimilarity is determined, the processing unit 102 then compares the dissimilarity $\varepsilon$ with the threshold matrix. On one hand, if the dissimilarity $\varepsilon$ is greater than the threshold matrix, it means that the health status of the mechanism 201 is deteriorated and the mechanism 201 or the circuit breaker 200 should be replaced to avoid sudden malfunction of the circuit breaker 200.

On the other hand, if the dissimilarity $\varepsilon$ is smaller than the threshold matrix, it means that the mechanism 201 is in normal operation. In this case, the health status may be determined by calculating the proximity between the dissimilarity $\varepsilon$ and the threshold matrix. For example, if the dissimilarity $\varepsilon$ is very close to but not more than the threshold matrix, it means that the mechanism 201 is in normal operation but not perfect. The processing unit 102 may then reduce the detection and analyzing interval to determine the dissimilarity more frequently. That is, the dissimilarity may be obtained and analyzed regularly, and the detection interval may be adjusted. The following describes how the above process is performed through several embodiments.

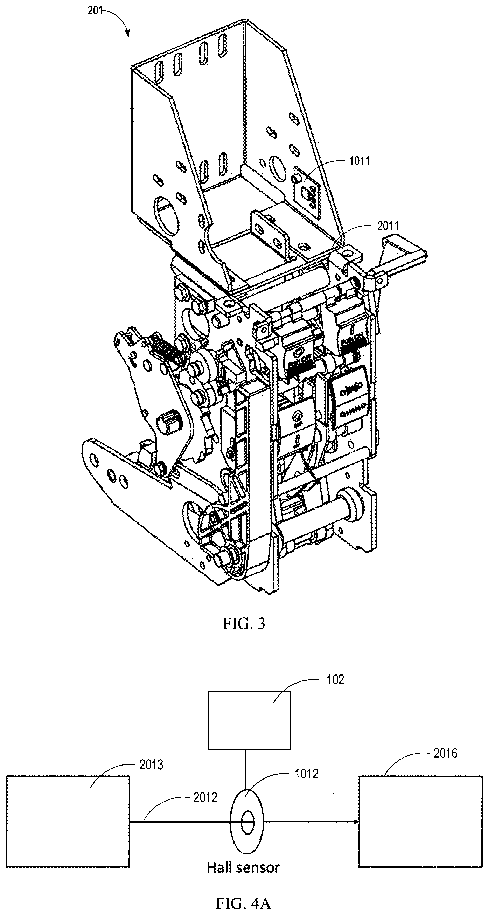

In some embodiments, the at least one mechanism 201 may comprise an operating mechanism 2011. The at least one sensor 101 may be coupled to the operating mechanism 2011 by various ways. For example, the sensor 101 may comprise a vibration sensor 1011 arranged on the operating mechanism 2011. The vibration sensor 1011 may be arranged on any suitable position of the operating mechanism 2011, for example, the vibration sensor 1011 may be arranged on a mounting bracket of the operating mechanism 2011, as shown in FIG. 3.

The vibration sensor 1011 may obtain vibration waveform data, such as vibration magnitude, related to the open/close operation of the operating mechanism 2011. It is appreciated that any suitable vibration sensor 1011 may be used to obtain vibration waveform data. For example, the vibration sensor 1011 may have measuring range of more than 300g ("g" refers to as gravitational acceleration) and have frequency range of more than 5kHz, preferably 10-30kHz.

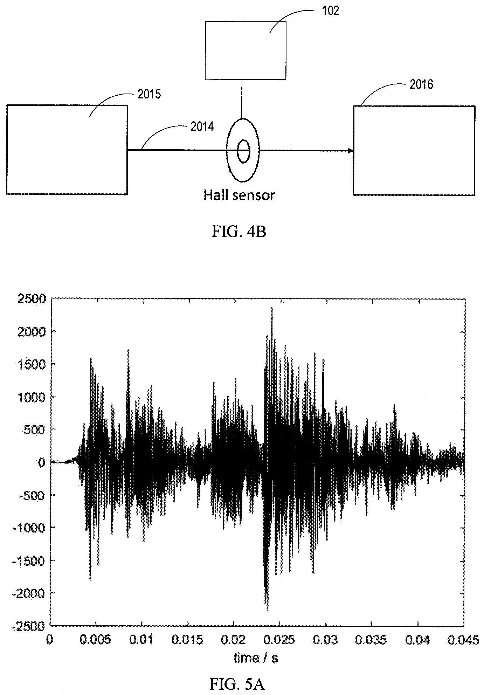

FIG. 5A shows a diagram of vibration waveform data obtained by the vibration sensor 1011. As shown in FIG. 5A, the vibration magnitude changes over time in the close operation of the operating mechanism 2011. To facilitate analysis of the vibration waveform data, in some embodiment, the vibration waveform data may be filtered. For example, in some embodiments, the vibration waveform data may be filtered based on Wavelet Transform (WT), such as Mallat algorithm. It is to be understood that the above implementation of filtering the vibration waveform data is merely for illustration, without suggesting any limitations as to the scope of the present disclosure. Any other suitable methods and/or algorithms are possible as well. For example, Low-pass filtering or the like may be used to filter the vibration waveform data.

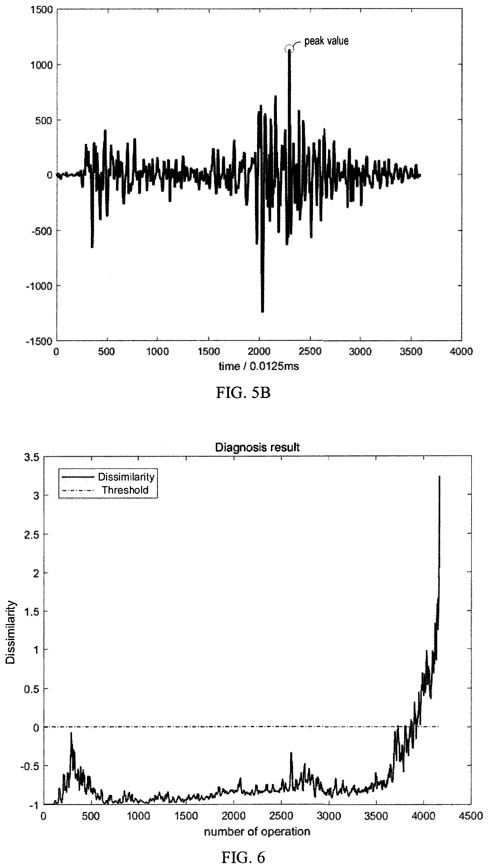

Consequently, the filtered vibration waveform data may be obtained by filtering to remove the noise in the vibration waveform data. The inventors found through experiments that when the operating mechanism 2011 is in the poor health status, some values, such as a peak value of the vibration magnitude, may be changed compared with the normal operation status of the operating mechanism 2011. In this case, the peak value determined from the filtered vibration waveform data may be chosen as a vibration feature value, as shown in FIG. 5B. Correspondingly, a vibration threshold matrix may record the peak values obtained when the operating mechanism 2011 is in the normal operating status, such as when the circuit breaker 200 was just put into use.

The dissimilarity of the vibration feature value may be determined by the above mentioned method. For example, the vibration feature value corresponding to one normal operation of the operating mechanism 2011 is 1225.4. Then the vibration feature value may be represented as the following matrix:

$$X(1) = [1225.4]^T.$$

The threshold matrix may record 50 such vibration feature values and may be represented as below:

$$D = \begin{bmatrix} 1225.4 \\ \vdots \\ 1335.9 \end{bmatrix}_{50 \times 1}.$$

For sake of discussion, it is assumed that one vibration feature value corresponding to one operation of the operating mechanism 2011 is 1005, represented as below:

$$X_{obs} = [1005]^T.$$

Then $X_{est}$ may be determined by the above equation (7). After calculation,

$$X_{est} = [3994]^T.$$

The dissimilarity $\varepsilon$ thereby may be determined using the above equation (4). The dissimilarity is then compared with threshold dissimilarity. As mentioned above, if the dissimilarity is greater than the threshold dissimilarity, it means that the operating mechanism 2011 may have the fault or be in the poor health status.

FIG. 6 shows a diagram of the vibration feature value as a function of the number of operations of the operating mechanism, wherein the threshold dissimilarity is specified as 0, as indicated by the dashed line. As shown in FIG. 6, with the increase in the number of the close operations, the dissimilarity gradually approaches the threshold dissimilarity and eventually exceeds the threshold dissimilarity after about 3900 operations. This means that the operating mechanism 2011 is in poor health status and needs to be replaced after 3900 operations.

It is to be understood that the circuit breaker 200 may be operated to achieve its function at this time. If this circuit breaker 200 is further used without replacement, the dissimilarity exceeds the threshold dissimilarity more and more until the operating mechanism 2011 is completely damaged after about 4200 operations, for example, one of the components in the operating mechanism 2011 may be broken. It is appreciated that the worse the health status, the father the difference between the dissimilarity and the threshold dissimilarity is.

Furthermore, it can be seen from the above that the fault may be predicted about 300 times before it occurs in the operating mechanism 2011. In this case, the user may replace the circuit breaker 200 or the operating mechanism 2011 more actively or in advance. This efficiently prevents the damage to the electrical appliance in the circuit due to the sudden fault of the operating mechanism 2011 or the circuit breaker 200. It is to be understood that the above implementation where the value "0" is selected as the threshold dissimilarity is merely for illustration, without suggesting any limitations as to the scope of the present disclosure. Any other suitable values are possible as well. For example, the threshold dissimilarity may be chosen to be larger to save costs, or the threshold dissimilarity may be chosen to be smaller to determine the fault earlier.

It is also to be understood that the above implementation of the threshold dissimilarity of vibration feature value comprising the peak value is merely for illustration, without suggesting any limitations as to the scope of the present disclosure. Any other suitable values being as the feature value is possible as well. For example, a valley value or an operating time determined from the filtered vibration waveform data may be chosen as well in some embodiments.

In some embodiments, the at least one mechanism 201 may comprise a tripping coil 2013. At least one sensor 101 may be coupled to the tripping coil 2013 by various ways. For example, the sensor 101 may comprise a hall sensor (refers to as a first hall sensor 1012 for ease of discussion) coupled to tripping coil 2013, as shown in FIG. 4A. The first hall sensor 1012 may be coupled to an electrical wire 2012 for connecting the tripping coil 2013 to a power supply 2016. It is to be understood that the above implementation of the first hall sensor 1012 being coupled to the electrical wire 2012 is merely for illustration, without suggesting any limitations as to the scope of the present disclosure. Any other suitable arrangements are possible as well. For example, in some embodiments, the first hall sensor 1012 may be coupled to the tripping coil itself or any suitable position related to the tripping coil 2013.

The first hall sensor 1012 may obtain current waveform data (refers to as a first current waveform data for ease of discussion) related to a tripping operation of the tripping coil 2013. It is appreciated that any suitable sensor may be used to obtain waveform data related to a tripping operation of the tripping coil 2013. For example, the sensor 101 may comprise a load sensor (not shown) to obtain a load on a transmission mechanism connected to the tripping coil 2013.

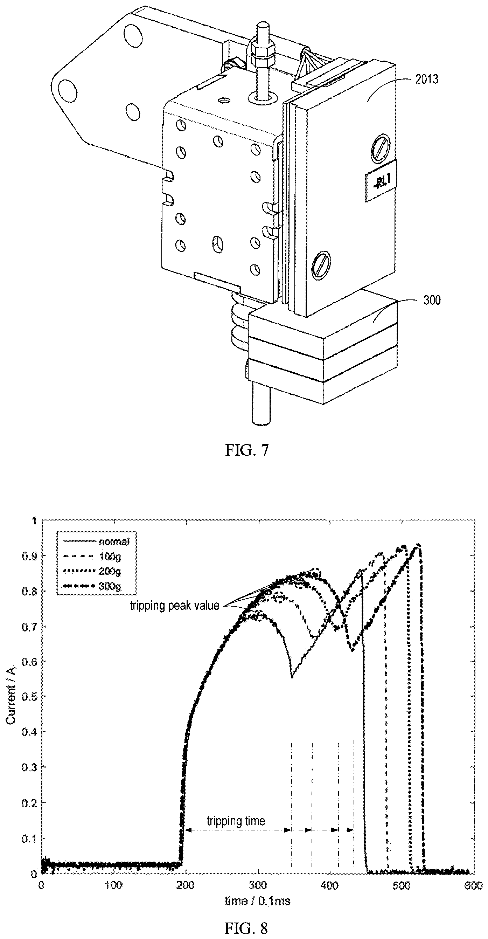

The inventors found that with the long term use, the load on the transmission mechanism connected to the tripping coil 2013 increases due to the deformation, increasing gap between the components, wear of the components or the like. Correspondingly, the power required by the tripping coil 2013 to take a tripping action through the transmission mechanism also gradually increases. To simulate this phenomenon, counterweights 300 with different weight (such as 100g, 200g and 300g) are loaded to the transmission mechanism connected to the tripping coil 2013, as shown in FIG. 7. The different weight corresponds to the load on the transmission mechanism due to the deformation, increasing gap between the components or the like.

Through experiments, the inventors further found that when the load on the transmission mechanism connected to the tripping coil 2013 increases, some values, such as an operating peak value and/or an operating time determined from the first current waveform data, may be changed compared with the normal operation status, as shown in FIG. 8. The tripping peak value corresponds to a peak value of the current pass through the electrical wire 2012 in tripping operation, and the tripping time corresponds to a time to trip the operating mechanism 2011.

FIG. 8 shows a diagram of the first current waveform data corresponding to the different loads applied to the transmission mechanism. It can be seen from FIG. 8 that with the increase of the load, the tripping peak value and/or the tripping time increases. The load on the transmission mechanism may correspond to the health status of the transmission mechanism. The greater the load on the transmission mechanism connected to the tripping coil 2013, the worse the health status of the transmission mechanism is.

In this case, the tripping peak value and/or the tripping time determined from the first current waveform data as shown in FIG. 8 may be chosen as tripping feature values. Correspondingly, a tripping threshold matrix may record the tripping peak values and/or the tripping time obtained when the tripping coil 2013 and its related transmission mechanism are in the normal operating status, such as when the circuit breaker 200 was just put into use.

The dissimilarity of the tripping feature values may be determined by the above mentioned method. The determined dissimilarity is then compared with threshold dissimilarity. As mentioned above, if the dissimilarity is greater than the threshold dissimilarity, it means that the transmission mechanism connected to the tripping coil 2013 may have the fault or be in the poor health status.

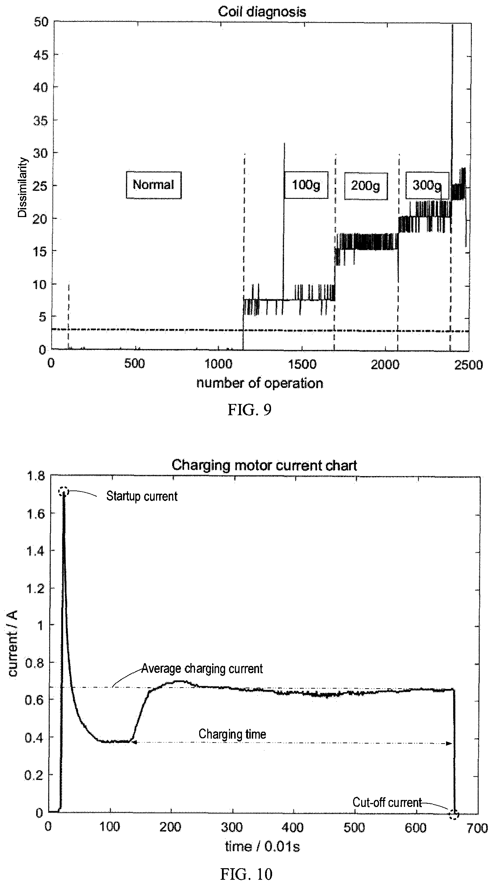

FIG. 9 shows a diagram of a tripping feature value as a function of the number of tripping operations of the tripping coil 2013, wherein the threshold dissimilarity is specified as 3, as indicated by the dashed line. As shown in FIG. 9, with the increase in the load on the transmission mechanism connected to the tripping coil 2013, the dissimilarity exceeds the threshold dissimilarity more and more. This means that the transmission mechanism connected to the tripping coil 2013 is in poor health status and needs to be replaced.

It is to be noted that the circuit breaker 200 may be operated to achieve its function when the load is on the transmission mechanism connected to the tripping coil 2013 due to the deformation, or the like. If this circuit breaker 200 is further used without replacement, the dissimilarity exceeds the threshold dissimilarity more and more until the transmission mechanism is completely damaged. That is, the increasing load on the transmission mechanism connected to the tripping coil 2013 may cause the fault in the transmission mechanism 2011.

When the load increases until the dissimilarity of the tripping feature values exceeds the threshold dissimilarity, the processing unit 102 determines that the transmission mechanism is in poor health status and needs to be replaced. In this case, the user may replace the circuit breaker 200 or the transmission mechanism connected to the tripping coil 2013 more actively or in advance. It is to be understood that the above implementation where the value "3" is selected as the threshold dissimilarity is merely for illustration, without suggesting any limitations as to the scope of the present disclosure. Any other suitable values are possible as well. For example, the threshold dissimilarity may be chosen to be larger to save costs, or the threshold dissimilarity may be chosen to be smaller to determine the fault earlier.

Furthermore, it is to be understood that the above implementation of the threshold dissimilarity of tripping feature value comprising the tripping peak value and/or tripping time is merely for illustration, without suggesting any limitations as to the scope of the present disclosure. Any other suitable values are possible as well. For example, a total operating time of the tripping coil determined from the first current waveform data may be chosen as well in some embodiments.

In some embodiments, the at least one mechanism 201 may comprise a charging motor 2015. At least one sensor 101 may be coupled to the charging motor 2015 by various ways. For example, the sensor 101 may comprise a hall sensor (refers to as a second hall sensor 1013 for ease of discussion) coupled to the charging motor 2015, as shown in FIG. 4B. The second hall sensor 1013 may be coupled to an electrical wire 2014 for connecting the charging motor 2015 to the power supply 2016. It is to be understood that the above implementation of the second hall sensor 1013 being coupled to the electrical wire 2014 is merely for illustration, without suggesting any limitations as to the scope of the present disclosure. Any other suitable arrangements are possible as well. For example, in some embodiments, the second hall sensor 1013 may be coupled to the charging motor 2015 itself or any suitable position related to the charging motor 2015.

The second hall sensor 1013 may obtain current waveform data (refers to as a second current waveform data for ease of discussion) related to a charging operation of the charging motor 2015. It is appreciated that any suitable sensor may be used to obtain waveform data related to the charging operation of the charging motor 2015. For example, the sensor 101 may comprise a load sensor (not shown) to obtain a load on a transmission mechanism connected to the charging motor 2015.

Similar to the above process of determining the tripping feature values of the tripping coil 2013, which will not be repeated here, the inventors further found that when the load on the transmission mechanism connected to the charging motor 2015 increases, some values, such as a startup current, a cut-off current, an average charging current and/or a charging time determined from the second current waveform data, may be changed compared with the normal operation status, as shown in FIG. 10.

As shown, the startup current corresponds to a peak value of the current pass through the electrical wire 2014 when the charging starts; the cut-off current corresponds to a value of the current pass through the electrical wire 2014 when the charging ends; the average charging current corresponds to an average of the current pass through the electrical wire 2014 during the charging and charging time corresponds to a time to charge the spring.

As mentioned above, at least one of the above values may be changed compared with the normal operation status, as shown in FIG. 10 when the load on the transmission mechanism connected to the charging motor 2015 increases. For example, in the normal operation status of the charging motor 2015, when the charging process is over, the current may be cut off and thus the cut-off current may "0". However, if some mechanisms, such as the transmission mechanism, connected to the charging motor 2015 are in poor health status, the cut-off current may not be "0" but other values.

In this case, the startup current, the cut-off current, the average charging current and/or the charging time determined from the second current waveform data as shown in FIG. 10 may be chosen as charging feature values. Correspondingly, a charging threshold matrix may record the startup current, the cut-off current, the average charging current and/or the charging time obtained when the charging motor 2015 and its related transmission mechanism are in the normal operating status, such as when the circuit breaker 200 was just put into use.

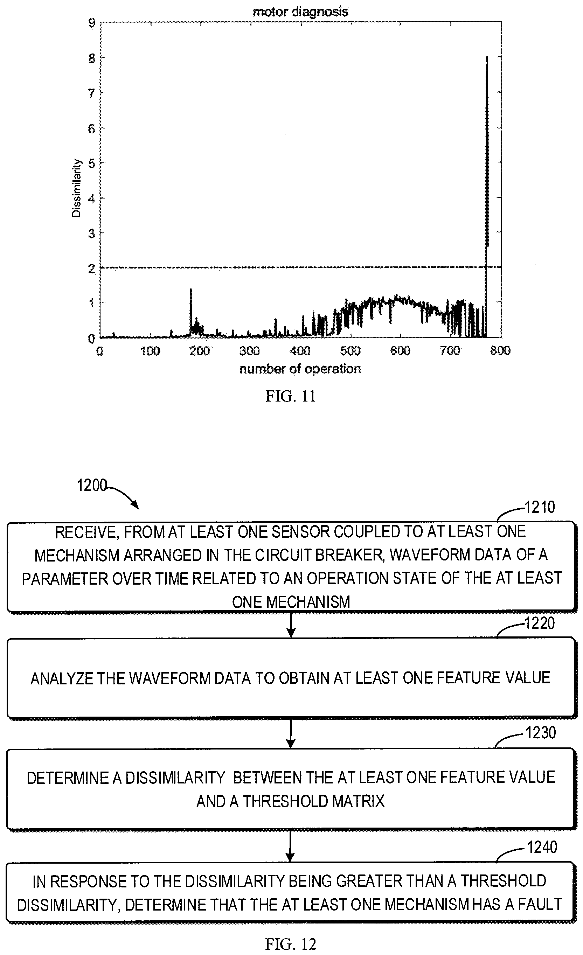

FIG. 11 shows a diagram of a charging feature value as a function of the number of tripping operations of the charging motor 2015, wherein the threshold dissimilarity is specified as 2, as indicated by the dashed line. As shown in FIG. 11, with the increase in the number of the charging operations, the dissimilarity gradually approaches the threshold dissimilarity and eventually exceeds the threshold dissimilarity after about 780 operations. This means that the transmission mechanism connected to the charging motor 2015 is in poor health status and needs to be replaced.

If the suitable threshold dissimilarity is chosen, the fault may be predicted before it occurs in the transmission mechanism connected to the charging motor 2015. In this case, the user may replace the circuit breaker 200 or the transmission mechanism connected to the charging motor 2015 more actively. This efficiently prevents the damage to the electrical appliance in the circuit due to the sudden fault of the transmission mechanism connected to the charging motor 2015 or the circuit breaker 200.

It is to be understood that the above implementation where the value "2" is selected as the threshold dissimilarity is merely for illustration, without suggesting any limitations as to the scope of the present disclosure. Any other suitable values are possible as well. For example, the threshold dissimilarity may be chosen to be larger to save costs, or the threshold dissimilarity may be chosen to be smaller to determine the fault earlier.

Moreover, it is to be understood that the above implementation of the threshold dissimilarity of charging feature values comprising the startup current, the cut-off current, the average charging current and/or the charging time is merely for illustration, without suggesting any limitations as to the scope of the present disclosure. Any other suitable values are possible as well. For example, a valley value or an operating time determined from the second current waveform data may be chosen as well in some embodiments.

The above describes embodiments of the fault diagnosis apparatus 100 according to embodiments of the present disclosure applied to the operating mechanism 2011, the tripping coil 2013 and/or the charging motor 2015, respectively. It is to be understood that the above implementations of applying the fault diagnosis apparatus 100 to the operating mechanism 2011, the tripping coil 2013 or the charging motor 2015 is merely for illustration, without suggesting any limitations as to the scope of the present disclosure. Any other suitable mechanisms to be applied to are possible as well. For example, the fault diagnosis apparatus 100 may be applied to a driving mechanism (not shown).

FIG. 12 shows a flowchart of a fault diagnosis method for the circuit breaker according to some other embodiments of the present disclosure. The method 1200 may be implemented by the processing unit 102 to perform the fault diagnosis. As shown, in block 1210, waveform data of a parameter over time is received from at least one sensor 101 coupled to at least one mechanism 201 arranged in the circuit breaker. The waveform data is related to an operation state of the at least one mechanism 201.

In block 1220, the waveform data is analyzed to obtain at least one feature value. In block 1230, a dissimilarity between the at least one feature value and a threshold matrix is determined. In block 1240, in response to the dissimilarity being greater than a threshold dissimilarity, the at least one mechanism 201 having a fault is determined.

As can be seen from the above embodiments of the present disclosure, the fault in the at least one mechanism 201 of the circuit breaker 200 may be determined in advance. In this case, the user may replace the circuit breaker 200 or the operating mechanism 2011 more actively. This efficiently prevents the damage to the electrical appliance in the circuit due to the sudden fault of the operating mechanism 2011 or the circuit breaker 200.

It should be appreciated that the above detailed embodiments of the present disclosure are only to exemplify or explain principles of the present disclosure and not to limit the present disclosure, which is defined by the appended claims.

**Claims**

1. A fault diagnosis apparatus (100) for a circuit breaker (200), comprising:

   at least one sensor (101) adapted to be coupled to at least one mechanism (201) arranged in the circuit breaker (200) and configured to obtain waveform data of a parameter over time, the waveform data related to an operation state of the at least one mechanism (201); and
   a processing unit (102) coupled to the at least one sensor (101) and configured to;

   analyze the waveform data to obtain at least one feature value;
   determine a dissimilarity between the at least one feature value and a threshold matrix; and
   in response to the dissimilarity being greater than a threshold dissimilarity, determine that the at least one mechanism (201) has a fault;
   wherein the threshold matrix records feature values corresponding to a normal operation status of the at least one mechanism (201);
   and wherein the threshold matrix records 50 or more vibration feature values.

2. The fault diagnosis apparatus (100) of claim 1, wherein the processing unit (102) determines the dissimilarity based on a Nonlinear State Estimate Technique (NSET).

3. The fault diagnosis apparatus (100) of claim 1, wherein the at least one mechanism (201) comprises an operating mechanism (2011) of the circuit breaker (200), and the at least one sensor (101) comprises a vibration sensor (1011) adapted to be arranged on the operating mechanism (2011), the vibration sensor (1011) configured to obtain vibration waveform data related to open/close operation of the operating mechanism (2011), wherein the processing unit (102) is preferably further configured to filter the vibration waveform data based on Wavelet Transform (WT), wherein the processing unit (201) is even more preferably configured to analyze the filtered vibration waveform data to obtain at least one vibration feature value, the at least one vibration feature value comprising a peak value determined from the filtered vibration waveform data.

4. The fault diagnosis apparatus (100) of claim 1, wherein the at least one mechanism (201) comprises a tripping coil (2013) of the circuit breaker (200), and the at least one sensor (101) comprises a first hall sensor (1012) adapted to be coupled to the tripping coil (2013), the first hall sensor (1012) configured to obtain first current waveform data related to a tripping operation of the tripping coil (2013, wherein the processing unit (201) is preferably configured to analyze the first current waveform data to obtain at least one tripping feature value, the at least one tripping feature value comprising an operating peak value and/or an operating time determined from the first current waveform data.

5. The fault diagnosis apparatus (100) of claim 1, wherein the at least one mechanism (201) comprises a charging motor (2015) of the circuit breaker (200), and the at least one sensor (101) comprises a second hall sensor (1013) adapted to be coupled to the charging motor (2015), the second hall sensor (1013) configured to obtain second current waveform data related to a charging operation of the charging motor (2014), wherein the processing unit (201) is preferably configured to analyze the second current waveform data to obtain at least one charging feature value, the at least one charging feature value comprising a startup current, a cut-off current, an average charging current and/or a charging time determined from the second current waveform data.

**6.** A circuit breaker (200) comprising the fault diagnosis apparatus (100) of any of claims 1-5.

**7.** A fault diagnosis method (1200) for a circuit breaker (200), comprising:

receiving (1210), from at least one sensor (101) coupled to at least one mechanism (201) arranged in the circuit breaker (200), waveform data of a parameter over time, the waveform data related to an operation state of the at least one mechanism (201);

analyzing (1220) the waveform data to obtain at least one feature value;

determining (1230) a dissimilarity between the at least one feature value and a threshold matrix; and

in response to the dissimilarity being greater than a threshold dissimilarity, determining (1240) that the at least one mechanism (201) has a fault;

the fault diagnosis method (1200) further comprising establishing the threshold matrix with feature values corresponding to a normal operation status of the at least one mechanism (201);

and wherein the threshold matrix records 50 or more vibration feature values.

**8.** The fault diagnosis method (1200) of claim 7, wherein the dissimilarity is determined based on a Nonlinear State Estimate Technique.

**9.** The fault diagnosis method (1200) of claim 7, comprising:

receiving, from a vibration sensor (1011) arranged on an operating mechanism (2011) of the circuit breaker (200), vibration waveform data related to open/close operation of the operating mechanism (2011).

**10.** The fault diagnosis method (1200) of claim 7, comprising:

receiving, from a first hall sensor (1012) coupled to a tripping coil (2013) of the circuit breaker (200), first current waveform data related to a tripping operation of the tripping coil (2013), and optionally comprising:

analyzing the first current waveform data to obtain at least one tripping feature value, the at least one tripping feature value comprising an operating peak value and/or an operating time determined from the first current waveform data.

**11.** The fault diagnosis method (1200) of claim 7, comprising:

receiving, from a second hall sensor (1013) coupled to a charging motor (2015) of the circuit breaker (200), second current waveform data related to a charging operation of the charging motor (2014).

**12.** The fault diagnosis method (1200) of claim 9, further comprising:

filtering the vibration waveform data based on Wavelet Transform (WT), and optionally comprising:

analyzing the filtered vibration waveform data to obtain at least one vibration feature value, the at least one vibration feature value comprising a peak value determined from the vibration waveform data.

**13.** The fault diagnosis method (1200) of claim 11, further comprising:

analyzing the second current waveform data to obtain at least one charging feature value, the at least one charging feature value comprising a startup current, a cut-off current, an average charging current and/or a charging time determined from the second current waveform data.

**Patentansprüche**

**1.** Fehlerdiagnosevorrichtung (100) für einen Leistungsschalter (200), umfassend:

mindestens einen Sensor (101), der geeignet ist mit mindestens einem in dem Leistungsschalter (200) angeordneten Mechanismus (201) gekoppelt zu werden und so konfiguriert ist, dass er Wellenformdaten eines Parameters über die Zeit erhält, wobei die Wellenformdaten mit einem Betriebszustand des mindestens einen Mechanismus (201) zusammenhängen; und

eine Verarbeitungseinheit (102), die mit dem mindestens einen Sensor (101) gekoppelt und konfiguriert ist, um;

die Wellenformdaten zu analysieren, um mindestens einen Merkmalswert zu erhalten;

Bestimmen einer Unähnlichkeit zwischen dem mindestens einen Merkmalswert und einer Schwellenwertmatrix; und

als Reaktion darauf, dass die Unähnlichkeit größer als eine Schwellenwert-Unähnlichkeit ist, zu bestimmen, dass der mindestens eine Mechanismus (201) einen Fehler aufweist;

wobei die Schwellenwertmatrix Merkmalswerte aufzeichnet, die mit einem normalen Betriebsstatus des mindestens einen Mechanismus (201) korrespondieren;
und wobei die Schwellenwertmatrix 50 oder mehr Vibrationsmerkmalswerte aufzeichnet.

2. Fehlerdiagnosevorrichtung (100) nach Anspruch 1, wobei die Verarbeitungseinheit (102) die Unähnlichkeit auf der Grundlage einer nichtlinearen Zustandsschätzungsmethode (NSET) bestimmt.

3. Fehlerdiagnosevorrichtung (100) nach Anspruch 1, wobei der mindestens eine Mechanismus (201) einen Betätigungsmechanismus (2011) des Leistungsschalters (200) umfasst und der mindestens eine Sensor (101) einen Vibrationssensor (1011) umfasst, der geeignet ist, dass er auf dem Betätigungsmechanismus (2011) angeordnet werden kann, wobei der Vibrationssensor (1011) so konfiguriert ist, dass er Vibrationswellenformdaten in Bezug auf den Öffnungs-/Schließvorgang des Betätigungsmechanismus (2011) erhält, wobei die Verarbeitungseinheit (102) vorzugsweise ferner konfiguriert ist, um die Vibrationswellenformdaten auf der Grundlage der Wavelet-Transformation (WT) zu filtern, wobei die Verarbeitungseinheit (201) noch bevorzugter konfiguriert ist, um die gefilterten Vibrationswellenformdaten zu analysieren, um mindestens einen Vibrationsmerkmalswert zu erhalten, wobei der mindestens eine Vibrationsmerkmalswert einen Spitzenwert umfasst, der aus den gefilterten Vibrationswellenformdaten bestimmt wird.

4. Fehlerdiagnosevorrichtung (100) nach Anspruch 1, wobei der mindestens eine Mechanismus (201) eine Auslösespule (2013) des Leistungsschalters (200) umfasst und der mindestens eine Sensor (101) einen ersten Hallsensor (1012) umfasst, der geeignet ist, dass er mit der Auslösespule (2013) gekoppelt werden kann, wobei der erste Hallsensor (1012) so konfiguriert ist, dass er erste Stromwellenformdaten in Bezug auf einen Auslösevorgang der Auslösespule (2013) erhält, wobei die Verarbeitungseinheit (201) vorzugsweise so konfiguriert ist, dass sie die ersten Stromwellenformdaten analysiert, um mindestens einen Auslösemerkmalwert zu erhalten, wobei der mindestens eine Auslösemerkmalwert einen Betriebsspitzenwert und/oder eine aus den ersten Stromwellenformdaten bestimmte Betriebszeit umfasst.

5. Fehlerdiagnosevorrichtung (100) nach Anspruch 1, wobei der mindestens eine Mechanismus (201) einen Lademotor (2015) des Leistungsschalters (200) umfasst, und der mindestens eine Sensor (101) einen zweiten Hallsensor (1013) umfasst, der so angepasst ist, dass er mit dem Lademotor (2015) gekoppelt werden kann, wobei der zweite Hallsensor (1013) so konfiguriert ist, dass er zweite Stromwellenformdaten erhält, die mit einem Ladevorgang des Lademotors (2014) in Beziehung stehen, wobei die Verarbeitungseinheit (201) vorzugsweise so konfiguriert ist, dass sie die zweiten Stromwellenformdaten analysiert, um mindestens einen Lademerkmalswert zu erhalten, wobei der mindestens eine Lademerkmalswert einen Einschaltstrom, einen Abschaltstrom, einen durchschnittlichen Ladestrom und/oder eine aus den zweiten Stromwellenformdaten bestimmte Ladezeit umfasst.

6. Leistungsschalter (200), umfassend die Fehlerdiagnosevorrichtung (100) nach einem der Ansprüche 1-5.

7. Fehlerdiagnoseverfahren (1200) für einen Leistungsschalter (200), umfassend:

Empfangen (1210) von Wellenformdaten eines Parameters über die Zeit von mindestens einem Sensor (101), der mit mindestens einem in dem Leistungsschalter (200) angeordneten Mechanismus (201) gekoppelt ist, wobei die Wellenformdaten mit einem Betriebszustand des mindestens einen Mechanismus (201) zusammenhängen;
Analysieren (1220) der Wellenformdaten, um mindestens einen Merkmalswert zu erhalten;
Bestimmen (1230) einer Unähnlichkeit zwischen dem mindestens einen Merkmalswert und einer Schwellenwertmatrix; und
Bestimmen (1240), dass der mindestens eine Mechanismus (201) einen Fehler aufweist, wenn die Unähnlichkeit größer als eine Schwellenwert-Unähnlichkeit ist;
wobei das Fehlerdiagnoseverfahren (1200) ferner das Erstellen der Schwellenwertmatrix mit Merkmalswerten umfasst, die mit einem normalen Betriebsstatus des mindestens einen Mechanismus (201) korrespondieren;
und wobei die Schwellenwertmatrix 50 oder mehr Vibrationsmerkmalswerte aufzeichnet.

8. Fehlerdiagnoseverfahren (1200) nach Anspruch 7, wobei die Unähnlichkeit auf der Grundlage einer nichtlinearen Zustandsschätzungsmethode bestimmt wird.

9. Fehlerdiagnoseverfahren (1200) nach Anspruch 7, umfassend:
Empfangen von Vibrationswellenformdaten, die sich auf den Öffnungs-/Schließvorgang des Betriebsmechanismus (2011) des Leistungsschalters (200) beziehen, von einem Vibrationssensor (1011), der an einem Betriebsmechanismus (2011) des Leistungsschalters (200) angeordnet ist.

10. Fehlerdiagnoseverfahren (1200) nach Anspruch 7, umfassend:
Empfangen, von einem ersten Hallsensor (1012), der mit einer Auslösespule (2013) des Leistungsschalters (200) gekoppelt ist, von ersten Stromwellenformdaten, die mit einem Auslösevorgang der Auslösespule (2013) zusammenhängen, und optional umfassend:
Analysieren der ersten Stromwellenformdaten, um mindestens einen Auslösemerkmalswert zu erhalten, wobei der mindestens eine Auslösemerkmalswert einen Betriebsspitzenwert und/oder eine aus den ersten Stromwellenformdaten bestimmte Betriebszeit umfasst.

11. Fehlerdiagnoseverfahren (1200) nach Anspruch 7, umfassend:
Empfangen von zweiten Stromwellenformdaten, die sich auf einen Ladevorgang des Lademotors (2014) beziehen, von einem zweiten Hallsensor (1013), der mit einem Lademotor (2015) des Leistungsschalters (200) verbunden ist.

12. Fehlerdiagnoseverfahren (1200) nach Anspruch 9, ferner umfassend:
Filtern der Vibrationswellenformdaten auf der Grundlage der Wavelet-Transformation (WT), und optional umfassend:
Analysieren der gefilterten Vibrationswellenformdaten, um mindestens einen Vibrationsmerkmalswert zu erhalten, wobei der mindestens eine Vibrationsmerkmalswert einen aus den Vibrationswellenformdaten bestimmten Spitzenwert umfasst.

13. Fehlerdiagnoseverfahren (1200) nach Anspruch 11, ferner umfassend:
Analysieren der zweiten Stromwellenformdaten, um mindestens einen Lademerkmalswert zu erhalten, wobei der mindestens eine Lademerkmalswert einen Anlaufstrom, einen Abschaltstrom, einen durchschnittlichen Ladestrom und/oder eine aus den zweiten Stromwellenformdaten bestimmte Ladezeit umfasst.

**Revendications**

1. Appareil de diagnostic de défaillance (100) pour disjoncteur (200), comprenant :

au moins un capteur (101) pouvant être couplé à au moins un mécanisme (201) disposé dans le disjoncteur (200) et configuré pour obtenir des données de forme d'onde d'un paramètre au fil du temps, les données de forme d'onde étant liées à un état de fonctionnement dudit au moins un mécanisme (201) ; et
une unité de traitement (102) couplée audit au moins un capteur (101) et configurée pour :

analyser les données de forme d'onde pour obtenir au moins une valeur de caractéristique ;
déterminer une dissemblance entre ladite au moins une valeur de caractéristique et une matrice de seuil ; et
en réponse au fait que la dissemblance est supérieure ou égale à un seuil de dissemblance, déterminer que ledit au moins un mécanisme (201) présente une défaillance ;
dans lequel la matrice de seuil enregistre des valeurs de caractéristique correspondant à un état de fonctionnement normal dudit au moins un mécanisme (201) ;
et dans lequel la matrice de seuil enregistre 50 valeurs de caractéristique de vibration ou plus.

2. Appareil de diagnostic de défaillance (100) selon la revendication 1, dans lequel l'unité de traitement (102) détermine la dissemblance sur la base d'une technique d'estimation d'état non linéaire (NSET).

3. Appareil de diagnostic de défaillance (100) selon la revendication 1, dans lequel ledit au moins un mécanisme (201) comprend un mécanisme de manoeuvre (2011) du disjoncteur (200), et ledit au moins un capteur (101) comprend un capteur de vibrations (1011) pouvant être disposé sur le mécanisme de manoeuvre (2011), le capteur de vibrations (1011) étant configuré pour obtenir des données de forme d'onde de vibration liées à l'opération d'ouverture/fermeture du mécanisme de manoeuvre (2011), l'unité de traitement (102) étant de préférence également configurée pour filtrer les données de forme d'onde de vibration sur la base d'une transformée en ondelettes (WT), l'unité de traitement (201) étant encore plus préférablement configurée pour analyser les données de forme d'onde de vibration filtrées pour obtenir au moins une valeur de caractéristique de vibration, ladite au moins une valeur de caractéristique de vibration comprenant une valeur de crête déterminée à partir des données de forme d'onde de vibration filtrées.

4. Appareil de diagnostic de défaillance (100) selon la revendication 1, dans lequel ledit au moins un mécanisme (201) comprend une bobine de déclenchement (2013) du disjoncteur (200), et ledit au moins un capteur (101) comprend un premier capteur à effet Hall (1012) pouvant être couplé à la bobine de déclenchement (2013), le premier capteur à effet Hall (1012) étant configuré pour obtenir des premières données de forme d'onde de courant liées à une opération de déclenchement de la bobine de déclenchement (2013), l'unité de traitement (201) étant de préférence configurée pour analyser les premières données de forme d'onde de courant pour obtenir au moins une valeur de caractéristique de déclenchement, ladite au moins une valeur de caractéristique de déclenchement comprenant une valeur de crête de manoeuvre et/ou un temps de manoeuvre déterminés à partir des premières données de forme d'onde de courant.

5.  Appareil de diagnostic de défaillance (100) selon la revendication 1, dans lequel ledit au moins un mécanisme (201) comprend un moteur de charge (2015) du disjoncteur (200), et ledit au moins un capteur (101) comprend un deuxième capteur à effet Hall (1013) pouvant être couplé au moteur de charge (2015), le deuxième capteur à effet Hall (1013) étant configuré pour obtenir des deuxièmes données de forme d'onde de courant liées à une opération de charge du moteur de charge (2014), l'unité de traitement (201) étant de préférence configurée pour analyser les deuxièmes données de forme d'onde de courant pour obtenir au moins une valeur de caractéristique de charge, ladite au moins une valeur de caractéristique de charge comprenant un courant de démarrage, un courant de coupure, un courant de charge moyen et/ou un temps de charge déterminés à partir des deuxièmes données de forme d'onde de courant.

6.  Disjoncteur (200) comprenant l'appareil de diagnostic de défaillance (100) selon l'une quelconque des revendications 1 à 5.

7.  Procédé de diagnostic de défaillance (1200) pour disjoncteur (200), comprenant les étapes consistant à :

    recevoir (1210), en provenance d'au moins un capteur (101) couplé à au moins un mécanisme (201) disposé dans le disjoncteur (200), des données de forme d'onde d'un paramètre au fil du temps, les données de forme d'onde étant liées à un état de fonctionnement dudit au moins un mécanisme (201) ;
    analyser (1220) les données de forme d'onde pour obtenir au moins une valeur de caractéristique ;
    déterminer (1230) une dissemblance entre ladite au moins une valeur de caractéristique et une matrice de seuil ; et
    en réponse au fait que la dissemblance est supérieure ou égale à un seuil de dissemblance, déterminer (1240) que ledit au moins un mécanisme (201) présente une défaillance ;
    le procédé de diagnostic de défaillance (1200) comprenant également l'étape consistant à établir la matrice de seuil avec des valeurs de caractéristique correspondant à un état de fonctionnement normal dudit au moins un mécanisme (201) ;
    et dans lequel la matrice de seuil enregistre 50 valeurs de caractéristique de vibration ou plus.

8.  Procédé de diagnostic de défaillance (1200) selon la revendication 7, dans lequel la dissemblance est déterminée sur la base d'une technique d'estimation d'état non linéaire.

9.  Procédé de diagnostic de défaillance (1200) selon la revendication 7, comprenant l'étape consistant à :
    recevoir, en provenance d'un capteur de vibrations (1011) disposé sur un mécanisme de manoeuvre (2011) du disjoncteur (200), des données de forme d'onde de vibration liées à l'opération d'ouverture/fermeture du mécanisme de manoeuvre (2011).

10. Procédé de diagnostic de défaillance (1200) selon la revendication 7, comprenant l'étape consistant à :
    recevoir, en provenance d'un premier capteur à effet Hall (1012) couplé à une bobine de déclenchement (2013) du disjoncteur (200), des premières données de forme d'onde de courant liées à une opération de déclenchement de la bobine de déclenchement (2013), et comprenant facultativement l'étape consistant à :
    analyser les premières données de forme d'onde de courant pour obtenir au moins une valeur de caractéristique de déclenchement, ladite au moins une valeur de caractéristique de déclenchement comprenant une valeur de crête de manoeuvre et/ou un temps de manoeuvre déterminés à partir des premières données de forme d'onde de courant.

11. Procédé de diagnostic de défaillance (1200) selon la revendication 7, comprenant l'étape consistant à :
    recevoir, en provenance d'un deuxième capteur à effet Hall (1013) couplé à un moteur de charge (2015) du disjoncteur (200), des deuxièmes données de forme d'onde de courant liées à une opération de charge du moteur de charge (2014).

12. Procédé de diagnostic de défaillance (1200) selon la revendication 9, comprenant également les étapes consistant à :

filtrer les données de forme d'onde de vibration sur la base d'une transformée en ondelettes (WT), et comprenant facultativement l'étape consistant à :

analyser les données de forme d'onde de vibration filtrées pour obtenir au moins une valeur de caractéristique de vibration, ladite au moins une valeur de caractéristique de vibration comprenant une valeur de crête déterminée à partir des données de forme d'onde de vibration.

13. Procédé de diagnostic de défaillance (1200) selon la revendication 11, comprenant également l'étape consistant à :
analyser les deuxièmes données de forme d'onde de courant pour obtenir au moins une valeur de caractéristique de charge, ladite au moins une valeur de caractéristique de charge comprenant un courant de démarrage, un courant de coupure, un courant de charge moyen et/ou un temps de charge déterminés à partir des deuxièmes données de forme d'onde de courant.

FIG. 1

FIG. 2

FIG. 3

Hall sensor

FIG. 4A

FIG. 4B

FIG. 5A

FIG. 5B

FIG. 6

FIG. 7

FIG. 8

FIG. 9

FIG. 10

FIG. 11

1200

┌─────────────────────────────────────────────────────────────────┐ 1210
│ RECEIVE, FROM AT LEAST ONE SENSOR COUPLED TO AT LEAST ONE         │
│ MECHANISM ARRANGED IN THE CIRCUIT BREAKER, WAVEFORM DATA OF A     │
│ PARAMETER OVER TIME RELATED TO AN OPERATION STATE OF THE AT LEAST │
│ ONE MECHANISM                                                     │
└─────────────────────────────────────────────────────────────────┘
                              │
                              ▼
┌─────────────────────────────────────────────────────────────────┐ 1220
│ ANALYZE THE WAVEFORM DATA TO OBTAIN AT LEAST ONE FEATURE VALUE    │
└─────────────────────────────────────────────────────────────────┘
                              │
                              ▼
┌─────────────────────────────────────────────────────────────────┐ 1230
│ DETERMINE A DISSIMILARITY BETWEEN THE AT LEAST ONE FEATURE VALUE  │
│ AND A THRESHOLD MATRIX                                            │
└─────────────────────────────────────────────────────────────────┘
                              │
                              ▼
┌─────────────────────────────────────────────────────────────────┐ 1240
│ IN RESPONSE TO THE DISSIMILARITY BEING GREATER THAN A THRESHOLD   │
│ DISSIMILARITY, DETERMINE THAT THE AT LEAST ONE MECHANISM HAS A FAULT │
└─────────────────────────────────────────────────────────────────┘

FIG. 12

**EP 3 775 946 B1**

**REFERENCES CITED IN THE DESCRIPTION**

**Patent documents cited in the description**

- CN 203259629 U
- WO 2016206056 A1
- CN 105975737 A